# EUROPÄISCHE PATENTSCHRIFT

(11) **EP 3 906 420 B1**
(45) Veröffentlichungstag und Bekanntmachung des Hinweises auf die Patenterteilung: **26.10.2022**
(21) Anmeldenummer: 21703847.0
(22) Anmeldetag: 29.01.2021
(51) Int. Cl.: G01R 33/30, G01R 33/387

(54) **PROBENKOPFSEITIGE PROBENVERLÄNGERUNG ZUR REDUKTION DER B0-FELDSTÖRUNG DES PROBENRÖHRCHENENDES**
PROBE-HEAD-SIDE PROBE EXTENSION FOR REDUCING B0 FIELD DISTURBANCE OF THE TEST TUBE END
EXTENSION DE SONDE CÔTÉ TÊTE DE SONDE PERMETTANT LA RÉDUCTION D'UNE PERTURBATION DE CHAMP B0 DE L'EXTRÉMITÉ DE TUBE À ESSAI

(30) Priorität: 21.02.2020 DE 102020202243
(43) Veröffentlichungstag der Anmeldung: 10.11.2021
(73) Patentinhaber: Bruker Switzerland AG, 8117 Fällanden (CH)
(72) Erfinder: SCHMIDIG, Daniel, 8200 Schaffhausen (CH)
(74) Vertreter: Kohler Schmid Möbus Patentanwälte
(86) Internationale Anmeldenummer: PCT/EP2021/052064
(87) Internationale Veröffentlichungsnummer: WO 2021/165014

(56) Entgegenhaltungen:
- EP-A1- 1 995 603
- EP-B1- 1 239 296
- EP-B1- 1 909 111

## Beschreibung

Die Erfindung betrifft eine NMR-Apparatur mit einem Magnetsystem zur Erzeugung eines homogenen statischen Magnetfelds B₀ entlang einer z-Richtung, mit einem Probenkopf, der ein HF-Sende- und Empfangs-Spulensystem umfasst sowie eine in z-Richtung verlaufende Öffnung zur Aufnahme eines Probenröhrchens, welches eine mittels NMR-Messung zu untersuchende Probensubstanz enthält, wobei ein Kompensationselement vorhanden ist, welches Störungen des homogenen Magnetfelds B₀ aufgrund der Probensubstanz und des Materials des Probenröhrchens an dem im Messbetrieb am weitesten in den Probenkopf ragenden Probenende des Probenröhrchens zumindest teilweise kompensiert, wobei das Kompensationselement einerseits außerhalb des im Messbetrieb der NMR-Apparatur in den Probenkopf ragenden Probenröhrchens und andererseits in z-Richtung unterhalb des Probenendes angeordnet, und dass das Kompensationselement in z-Richtung beweglich, insbesondere verschiebbar, gelagert ist.

Eine solche NMR-Apparatur ist aus der EP 1 909 111 B1 (= Referenz [7]) bekannt geworden.

### Hintergrund der Erfindung

Die vorliegende Erfindung befasst sich allgemein mit dem Gebiet der Kernspinresonanz (nuclear magnetic resonance ="NMR"), insbesondere mit Probenköpfen für NMR-Geräte. Die NMR-Spektroskopie stellt ein leistungsfähiges Verfahren der instrumentellen Analytik dar, insbesondere zur Analyse von Proben-Zusammensetzungen oder zur Strukturbestimmung von Stoffen in Proben.

Die Messsubstanz wird typischerweise in fester oder flüssiger Form in ein im Wesentlichen zylindrisches Probenröhrchen gefüllt und zur Messung in den NMR-Probenkopf verbracht. Dort ist die Messprobe einem starken, in einer z-Richtung homogenen, statischen Magnetfeld B₀ ausgesetzt, wodurch es zur Ausrichtung von Kernspins in der Messsubstanz der Probe kommt. Sodann werden dazu orthogonale hochfrequente elektromagnetische Impulse in x- oder y-Richtung in die Probe eingestrahlt. Die zeitliche Entwicklung dieser Kernspins der Probe erzeugt wiederum hochfrequente elektromagnetische Felder, welche in der NMR-Apparatur detektiert werden. Aus den detektierten HF-Feldern können Informationen über die Eigenschaften der Probe integral über einen gewissen räumlichen Bereich erhalten werden. Insbesondere kann aus der Lage und Intensität von NMR-Linien auf die chemische Zusammensetzung sowie die chemischen Bindungsverhältnisse in der Probe geschlossen werden; siehe etwa US 9,500,726 B2 ≈ DE 10 2013 204 131 B3 (= Referenz [2]).

Problematisch ist ein Suszeptibilitätssprung am unteren axialen Ende des Probenröhrchens, der durch den Übergang von Probensubstanz beziehungsweise dem Material des Probenröhrchens und dem in z-Richtung darunter liegenden Raumbereich auftritt, der meist von einem Temperierfluid erfüllt ist. Dieser Suszeptibilitätssprung aufgrund der endlichen axialen Länge des Probenröhrchens verursacht eine Störung des homogenen Magnetfeldes B₀ im NMR-System.

### Verlängerte Eintauchtiefe

In vielen Fällen wird das Probenröhrchen in z-Richtung einfach so positioniert, dass die Störung des Bo-Feldes durch den Suszeptibilitätssprung am Probenende genügend weit vom aktiven Messvolumen der Probe entfernt ist, sodass diese Bo-Feldstörung mit Hilfe eines Shimsystems korrigiert werden kann.

Beispielsweise beschreiben die US 6,563,317 B2 ≈ EP 1 239 296 B1 ≈ DE 101 11 672 C2 (= Referenz [3]) eine Vorrichtung zur genauen Zentrierung eines NMR-Probengläschens, bei welcher das zur Messung in den NMR-Probenkopf eingebrachte Probenröhrchen an seinem unteren Ende gegen einen festen Anschlag stößt, der eine ausreichend große Distanz in z-Richtung vom Messvolumen entfernt ist, das sich im Bereich zwischen den HF-Spulen befindet.

Nachteilig ist hierbei freilich, dass eine bestimmte, deutlich größere Menge an Probenmaterial benötigt wird, welche überhaupt kein NMR-Signal liefert und nur zur Verlängerung der Probe in z-Richtung verwendet wird.

### Kompensationsstopfen

Eine andere Möglichkeit zur Vermeidung einer Störung des Bo-Feldes durch den Suszeptibilitätssprung am Probenende besteht darin, das Material des Probenröhrchens so zu wählen, dass die Suszeptibilität des Röhrchen-Materials der Suszeptibilität der Probenflüssigkeit entspricht. Der untere Teil des Probenröhrchens wird dann anstatt mit Probenflüssigkeit mit diesem Material gefüllt. Zusätzlich kann ein Stopfen aus entsprechendem Material auch über der Oberfläche der Probenflüssigkeit eingesetzt werden.

Derartige Probenröhrchen mit Stopfen bietet die Firma Wilmad-Lab Glass http://www.wilmad-labglass.com (= Referenz [4]) als "Doty Susceptibility-Matched Sample Plugs for High Resolution Liquids NMR" an.

Nachteilig ist hier allerdings die relativ aufwändige Handhabung dieser sogenannten Kompensationsstopfen. Sie müssen nämlich für jedes Probenröhrchen separat von Hand eingesetzt werden.

### Speziell geformtes Ende des Probenröhrchens

Eine weitere Möglichkeit zur Verkleinerung einer Störung des Bo-Feldes durch den Suszeptibilitätssprung am Probenende kann darin bestehen, das Ende des Probenröhrchens (d.h. das Glas am axialen Ende des Probenröhrchens) so zu formen, dass die magnetische Störung des Bo-Feldes minimiert wird.

Die Störung durch das Probenende kann jedoch auf diese Weise normalerweise nicht komplett zum Verschwinden gebracht werden. Außerdem muss jedes Probenröhrchen aufwändig individuell geformt werden. Die gewünschte Form kann auch immer nur näherungsweise erreicht werden.

### Steuerung der Suszeptibilität des Probenröhrchens durch Fluide

Die US 5,545,994 A (= Referenz [5]) schlägt als Möglichkeit einer Verringerung der Störung des Bo-Feldes im NMR-Spektrometer durch die Suszeptibilität des Probenröhrchens vor, die gesamte nach außen hin wirksame Suszeptibilität des Probenröhrchens mit Hilfe von geeigneten, das Probenröhrchen umströmenden Fluiden auf einen bestimmten gewünschten Wert zu bringen. Dies erfordert natürlich einen erheblichen apparativen Aufwand für die Fluid-Zu- und Abführung sowie eine ständige feinfühlige Regelung im NMR-Betrieb. Darüber hinaus sind derartige Fluide für die Verwendung bei der Temperierung zu teuer.

### Elektronische Regelung der Suszeptibilität des Probenröhrchens

Ein ganz anderer Ansatz, wie er in US 5,684,401 A (= Referenz [6]) vorgeschlagen wird, sieht eine Regelung zur Kompensation der Störung des homogenen Magnetfeldes B₀ durch das Probenröhrchen vor. Dabei soll das HF-Empfangs-Spulensystem derart modifiziert werden, dass parallele Wicklungen von Mikro-Spulen so geregelt werden, dass das Magnetfeld um das Probenröhrchen herum näherungsweise homogen ist. Diese muss dann im Messbetrieb elektronisch auf einen gewünschten Wert geregelt werden, was natürlich einen gewissen Aufwand erfordert und auch im Langzeit-Betrieb Störungen unterliegt.

### Einsatz eines Kompensationselements im Probenröhrchen

In der US 4,365,199 A (= Referenz [1]) wird eine Anordnung mit den mit den meisten der eingangs genannten Merkmale beschrieben. Aus Referenz [1]) geht hervor, dass vor der NMR-Messung ein Kompensationselement in Form eines zylindrischen, stabförmigen Einsatzes in das Probenröhrchen eingeschoben werden soll. Dieser Einsatz kann auch zwei axial voneinander beabstandete Stopfen umfassen, ähnlich wie in Referenz [4] vorgeschlagen. Allerdings ist das Kompensationselement nach Referenz [1] nicht dazu ausgelegt, eine Störung des Bo-Feldes durch den Suszeptibilitätssprung am Probenende zu kompensieren. Auf diese Problematik wird in dem Dokument überhaupt nicht eingegangen. Vielmehr soll das Kompensationselement nach Referenz [1] Temperaturschwankungen im Probenröhrchen reduzieren und erzeugte Wärme gleichmäßiger verteilen.

Eine generische Anordnung mit sämtlichen eingangs genannten Merkmalen ist auch bekannt aus US 7,514,922 B2 ≈ EP 1 909 111 B1 ≈ DE 10 2006 046 888 B4 (=Referenz [7]).

### Aufgabe der Erfindung

Der vorliegenden Erfindung liegt demgegenüber die Aufgabe zugrunde, einen Probenkopf für eine NMR-Apparatur der eingangs beschriebenen Art mit möglichst unaufwändigen technischen Mitteln dahingehend zu verbessern, dass die oben diskutierten Nachteile bekannter gattungsgemäßer Anordnungen vermieden werden. Insbesondere soll mit der vorliegenden Erfindung der Suszeptibilitätssprung bzw. die Bo-Feldstörung im unteren Bereich der NMR-aktiven Probenflüssigkeit, verursacht durch das untere Ende des Probenröhrchens, verkleinert werden.

### Kurze Beschreibung der Erfindung

Diese -im Detail betrachtet relativ anspruchsvolle- Aufgabe wird durch die vorliegende Erfindung auf ebenso überraschend einfache und kostengünstige, aber sehr wirkungsvolle Weise dadurch gelöst, dass das Kompensationselement auf einem Luftkissen oder auf einer in Richtung der z-Achse wirkenden Federvorrichtung gelagert ist, wobei das Luftkissen, auf welchem das Kompensationselement gelagert ist, durch einen Temperiergasstrom im Probenkopf gebildet wird. Eine Umströmung des Kompensationselements und des Probenröhrchens mit Temperierfluid ist auch bei der zweiten Alternative möglich und in der Regel verwirklicht.

Das Kompensationselement kann sich im Betrieb problemlos an das Probenröhrchen anschmiegen. Damit lässt sich ein Haupt-Gedanke der vorliegenden Erfindung -nämlich eine axiale Weiterführung der Suszeptibilität des mit Messsubstanz gefüllten Probenröhrchens von dessen Ende in z-Richtung weiter nach unten, also eine Art "künstlicher axialer Verlängerung" des Probenröhrchens hinsichtlich seiner Suszeptibilität- besonders feinfühlig und individuell auf unterschiedliche Proben-Geometrien abgestimmt verwirklichen. Dadurch wird die Bo-Feldstörung aufgrund des -normalerweise immer ziemlich «abrupten»- axialen Probenendes faktisch in z-Richtung nach unten, also weiter weg vom aktiven NMR-Bereich des HF-Spulensystems geschoben, was schließlich auch zu einer besseren Performance der NMR-Apparatur, insbesondere in einem Experiment zur Unterdrückung des NMR-Signals vom Lösungsmittel führt. Dabei werden unterschiedliche Resonanzfrequenzen, Relaxationszeiten oder Selbstdiffusionskoeffizienten ausgenutzt.

Im Vergleich zum Stand der Technik, etwa nach den Referenzen [1] und [4], bei welchem das Kompensationselement vor jeder NMR-Messung innerhalb des Probenröhrchens appliziert werden muss, schlägt die vorliegende Erfindung vor, das Kompensationselement räumlich außerhalb des Probenröhrchens zu platzieren. Damit wird das gesamte Handling bedeutend vereinfacht. Es bedarf auch keiner speziell ausgestalteten Probenröhrchen und außerdem wird die Probensubstanz nicht berührt und daher auch nicht beeinträchtigt.

Ein weiterer wesentlicher Unterschied der vorliegenden Erfindung zu den bekannten Geräten liegt in der erfindungsgemäß vorgeschriebenen Anordnung des Kompensationselements in z-Richtung unterhalb des Probenendes. Dort kann das Kompensationselement beweglich in die Struktur des Probenkopfes in diesem Bereich eingefügt werden und steht jedenfalls nicht mehr im Wege.

Natürlich muss das Kompensationselement bei der Erfindung -wie auch im Stand der Technik- magnetisch an die Suszeptibilität am axialen Ende des Probenröhrchen -vorzugsweise auch unter Berücksichtigung der Suszeptibilität der Probensubstanz in diesem Bereich- angepasst sein, um den Suszeptibilitätssprung am Probenende zu kompensieren und dadurch Störungen des Bo-Feldes im NMR-Spektrometer ganz oder zumindest größtenteils zu vermeiden.

### Bevorzugte Ausführungsformen und Weiterbildungen der Erfindung

Ganz besonders bevorzugt ist eine Klasse von Ausführungsformen der erfindungsgemäßen NMR-Apparatur, bei denen das Kompensationselement derart ausgebildet ist, dass es die Querschnittsgeometrie des Probenröhrchens in z-Richtung fortsetzt. Damit lässt sich der Suszeptibilitätssprung am Probenende besonders weitgehend kompensieren. Übliche Probenröhrchen haben einen kreisförmigen Querschnitt. Bevorzugte Kompensationselemente weisen diesen mit dem gleichen Durchmesser auf.

Ergänzend oder alternativ kann bei weiteren -in der Zeichnung nicht eigens dargestellten- Ausführungsformen der Erfindung das Kompensationselement derart ausgebildet sein, dass das Probenröhrchen im Messbetrieb nur an einem Punkt auf der z-Achse auf dem Kompensationselement aufliegt. Auf diese Weise wird der Reibungswiderstand zwischen Probenröhrchen und Kompensationselement minimiert, was für eine Rotation der Probe in einem Messvorgang vorteilhaft ist.

Vorteilhaft sind auch Ausführungsformen der Erfindung, bei denen das Kompensationselement derart ausgebildet ist, dass sich seine Kontur an die Kontur des Probenröhrchens am Probenende geometrisch anschmiegt. Insbesondere kann das Probenröhrchen am Probenende als Halbkugel und das Kompensationselement in seinem dem Probenröhrchen gegenüberliegenden Abschnitt als Halbkugelschale ausgebildet sein.

Weitere vorteilhafte Ausführungsformen der Erfindung zeichnen sich dadurch aus, dass das Kompensationselement aus einem Material gebildet oder mit diesem beschichtet ist, welches den Reibungswiderstand zwischen dem Kompensationselement und dem im Messbetrieb daran anliegenden Probenröhrchen minimiert, insbesondere Polytetrafluorethylen oder eine Keramiklegierung, wobei das Material vorzugsweise mittlere eine Suszeptibilität χ zwischen 0,4cgs und 0,8cgs aufweist.

Besonders bevorzugt sind auch Ausführungsformen der erfindungsgemäßen NMR-Apparatur, die dadurch gekennzeichnet sind, dass das Kompensationselement so ausgestaltet ist, dass ein Fluidfluss, vorzugsweise ein Temperiergasstrom, vom Kompensationselement in einen Ringspalt zwischen der Außenhülle des im Messbetrieb in den Probenkopf ragenden Probenröhrchens und einem das Probenröhrchen in dieser Position umgebenden Wandelement des Probenkopfes, welches insbesondere das HF-Sende- und Empfangs-Spulensystem trägt, ermöglicht und möglichst wenig behindert wird.

Ein NMR-Probenkopf umfasst, wie üblich, eine Messprobenkammer, die im Betrieb eine Messprobe aufnimmt und optional aus einem Material mit geringer thermischer Leitfähigkeit bestehen kann (beispielsweise aus Glas, Quarz, Teflon, etc.). Der Probenkopf enthält eine erste Sende-/Empfangsspule, welche die Messprobenkammer umgibt oder von dieser umgeben wird. Vorzugsweise umfasst der Messkopf auch ein Netzwerk zum Abstimmen verschiedener Resonanzfrequenzen auf einer ersten Sende-/Empfangsspule.

Weiterhin kann der Probenkopf optional auch eine zweite Sende-/Empfangsspule umfassen, die auf weitere Messkerne abgestimmt sein kann, z.B. die Lockfrequenz. In anderen Ausführungsformen enthält der Messkopf eine weitere Messprobe mit einer Substanz, die durch eine zweite oder dritte Sende-/Empfangsspule detektiert wird und als Referenzsignal für den Lock verwendet wird.

Der erfindungsgemäß gestaltete und in der NMR-Apparatur angeordnete NMR-Probenkopf ist durch die Merkmale von Anspruch 1 definiert. Er zeichnet sich dadurch aus, dass das Kompensationselement auf einer in Richtung der z-Achse wirkenden Federvorrichtung gelagert ist, oder dass das Kompensationselement in z-Richtung beweglich auf einem Luftkissen gelagert ist, und dass das Luftkissen, auf welchem das Kompensationselement gelagert ist, durch einen Temperiergasstrom im Probenkopf gebildet wird.

Ergänzend oder alternativ kann bei weiteren Ausführungsformen des erfindungsgemäß ausgestalteten NMR-Probenkopfes das Kompensationselement frei drehbar um die z-Achse gelagert sein, so dass es insbesondere im Messbetrieb mit dem Probenröhrchen mitrotieren kann.

In jedem Fall sollte das Kompensationselement derart im Probenkopf implementiert sein, dass eine Rotation des Probenröhrchens um seine z-Achse nicht be- oder gar verhindert wird.

Generell kann das erfindungsgemäß ausgestaltete Kompensationselement massiv oder hohl aufgebaut sein. Der erhöhten Stabilität und einfacheren Herstellbarkeit des Kompensationselements im ersteren Fall steht eine nicht unbeachtliche Material- und damit auch Gewichtseinsparung im letzteren Fall gegenüber.

Vorzugsweise ist der erfindungsgemäße NMR-Probenkopf so aufgebaut, dass das Kompensationselement gegen unkontrolliertes Entfernen aus dem Probenkopf gesichert ist. Dies kann insbesondere durch ein fest mit dem Probenkopf verbundenes, in das Kompensationselement eingreifendes Halteelement bewirkt werden.

Bei weiteren bevorzugten Ausführungsformen der Erfindung ist in z-Richtung ein oberer axialer Anschlag für das Kompensationselement im Probenkopf vorhanden, sodass das Kompensationselement nicht versehentlich aus dem Probenkopf herausfliegen kann.

Weiterbildungen der oben beschriebenen Ausführungsformen, bei welchen das Kompensationselement so ausgestaltet ist, dass ein Fluidfluss in einen Ringspalt zwischen der Außenhülle des im Messbetrieb in den Probenkopf ragenden Probenröhrchens und einem das Probenröhrchen in dieser Position umgebenden Wandelement des Probenkopfes vom Kompensationselement möglichst wenig behindert wird, können sich vorteilhaft dadurch auszeichnen, dass das Kompensationselement Fluiddurchlässe, insbesondere Gasdurchlässe aufweist, insbesondere an seiner Außenseite in Form von Längsrillen parallel zur z-Richtung und/oder auf der z-Achse in Form einer axialen Durchgangsbohrung.

In der Praxis bewähren sich Ausführungsformen des erfindungsgemäß ausgestalteten NMR-Probenkopfes, bei welchen das Kompensationselement eine Suszeptibilität χ aufweist, die typischerweise zwischen der mittleren Suszeptibilität des Probenröhrchens und einer typischen Suszeptibilität der Probensubstanz liegt, vorzugsweise eine Suszeptibilität χ zwischen 0,3cgs und 1cgs, insbesondere eine Suszeptibilität χ zwischen 0,4cgs und 0,8cgs. Typische mit dem Material der Probensubstanz oftmals vermischte Lösungsmittel sind beispielsweise Aceton mit einer Suszeptibilität χ = 0,46cgs oder Glycerol mit einer Suszeptibilität χ = 0,78cgs.

Ganz besonders bevorzugt ist schließlich eine Klasse von Ausführungsformen der Erfindung, bei welchen sich der NMR-Probenkopf dadurch auszeichnet, dass das Kompensationselement mit Suszeptibilität χ im Probenkopf austauschbar gestaltet ist gegen ein anderes Kompensationselement mit einer unterschiedlichen Suszeptibilität χ'. Auf diese Weise kann eine besonders feinfühlige und effektive Suszeptibilitätsanpassung erfolgen und damit Störungen des Bo-Feldes im NMR-Spektrometer ganz oder zumindest größtenteils vermieden werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematische Vertikalschnittansicht einer ersten Ausführungsform des Probenkopfes für eine erfindungsgemäße NMR-Apparatur mit einem Kompensationselement, das auf einer in Richtung der z-Achse wirkenden Federvorrichtung beweglich gelagert ist;
- Fig. 2: einen NMR-Probenkopf wie in Fig. 1, jedoch keine Ausführungsform gemäß den vorliegenden Patentansprüchen, sondern einfacher, mit einem starren, als Anschlag für das Probenröhrchen in Richtung der z-Achse wirkenden, in den Probenkopf integrierten Kompensationselement;
- Fig. 3a: einen sehr schematischen Vertikalschnitt durch eine Ausführungsform des erfindungsgemäß vorgesehenen Kompensationselements mit Gasdurchlässen parallel zur z-Richtung;
- Fig. 3b: einen schematischen Horizontalschnitt durch eine Ausführungsform des Kompensationselements gemäß Fig. 3a mit feinen, zur z-Richtung parallelen Längsrillen an der Außenseite sowie mit einer axialen Durchgangsbohrung;
- Fig. 3c: einen schematischen Horizontalschnitt durch eine Ausführungsform des Kompensationselements ähnlich dem in Fig. 3b gezeigten, jedoch mit gröberen Längsrillen;
- Fig. 4a: einen schematischen Vertikalschnitt durch eine Ausführungsform des erfindungsgemäß vorgesehenen Kompensationselements mit einem fest mit dem Probenkopf verbundenen, in das Kompensationselement eingreifenden Halteelement in einer mittleren z-Position; und
- Fig. 4b: das Kompensationselement aus Fig. 4a, jedoch mit dem Halteelement in einer z-Position kurz vor dem Anschlag.

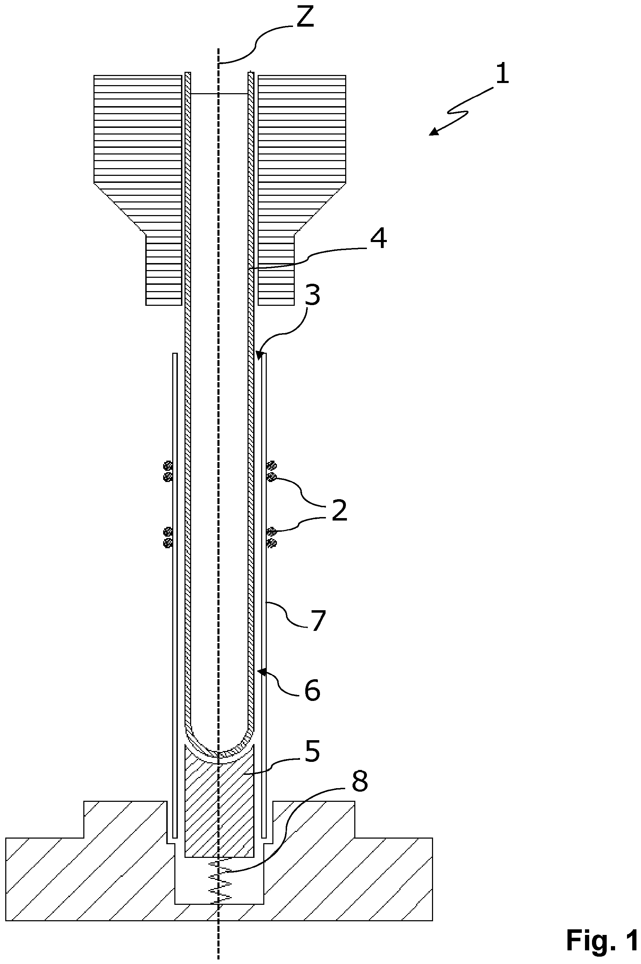

Die Figuren 1 bis 4b der Zeichnung zeigen jeweils in schematischen Ansichten mit unterschiedlichem Detail bevorzugte Ausführungsformen der erfindungsgemäßen NMR-Apparatur im Bereich des Probenkopfes.

Eine derartige NMR-Apparatur mit einem -in der Zeichnung aus Gründen der Übersichtlichkeit nicht eigens dargestellten- Magnetsystem zur Erzeugung eines homogenen statischen Magnetfelds B₀ entlang einer z-Richtung umfasst einen **Probenkopf 1; 1',** der ein **HF-Sende- und Empfangs-Spulensystem 2** aufweist sowie eine **in z-Richtung verlaufende Öffnung 3** zur Aufnahme eines **Probenröhrchens 4,** das im Betrieb eine mittels NMR-Messung zu untersuchende Probensubstanz enthält, wobei ein **Kompensationselement 5; 5'; 5"; 5‴** vorhanden ist, welches Störungen des homogenen Magnetfelds B₀ aufgrund der Probensubstanz und des Materials des Probenröhrchens 4 an dem im Messbetrieb am weitesten in den Probenkopf 1 ragenden axialen Probenende des Probenröhrchens 4 zumindest teilweise kompensiert.

Die erfindungsgemäße NMR-Apparatur zeichnet sich gegenüber den bekannten Anordnungen nach dem Stand der Technik dadurch aus, dass das Kompensationselement 5; 5'; 5"; 5‴ *außerhalb* des im Messbetrieb der NMR-Apparatur in den Probenkopf 1; 1' ragenden Probenröhrchens 4 sowie in z-Richtung *unterhalb des Probenendes* angeordnet ist.

In **Fig. 1** ist eine bevorzugte Ausführungsform des innerhalb der erfindungsgemäßen NMR-Apparatur angeordneten erfindungsgemäßen Probenkopfs 1 abgebildet. Letzterer umfasst ein Kompensationselement 5, welches derart ausgebildet ist, dass es die Querschnittsgeometrie des Probenröhrchens 4 in z-Richtung fortsetzt, wobei sich seine Kontur an die Kontur des Probenröhrchens 4 am Probenende anschmiegt. An seinem axialen Ende sind das Probenröhrchen 4 kugelig und das Kompensationselement 5 in seinem dem Probenröhrchen 4 gegenüberliegenden Abschnitt als Kugelkalotte, insbesondere als Halbkugelschale ausgebildet.

Vorteilhaft ist der Außenradius des kugeligen Endes des Probenröhrchen kleiner als der Innenradius der Kugelkalotte des Kompensationselementes. Hierdurch kann ein punktförmiger Kontakt zwischen Kompensationselement und Probenröhrchen erreicht werden. Bei Rotation des Probenröhrchens innerhalb des Probenkopfes wird die Reibung zum Kompensationselement verringert, wobei sich die Konturen von Probenröhrchen und Kompensationselement nach wie vor aneinander anschmiegen. Dies ist auch für ein starr in Teile des Probenkopfs integriertes Kompensationselement, welches keine Ausführungform der Erfindung darstellt, geeignet.

Weiter ist das Kompensationselement 5 so ausgestaltet, dass ein Fluidfluss, etwa ein Temperiergasstrom, vom Kompensationselement 5 in einen **Ringspalt 6** zwischen der Außenhülle des im Messbetrieb in den Probenkopf 1 ragenden Probenröhrchens 4 und einem das Probenröhrchen 4 in dieser Position **umgebenden Wandelement 7** des Probenkopfes 1, welches insbesondere das HF-Sende- und Empfangs-Spulensystem 2 trägt, möglichst wenig behindert wird.

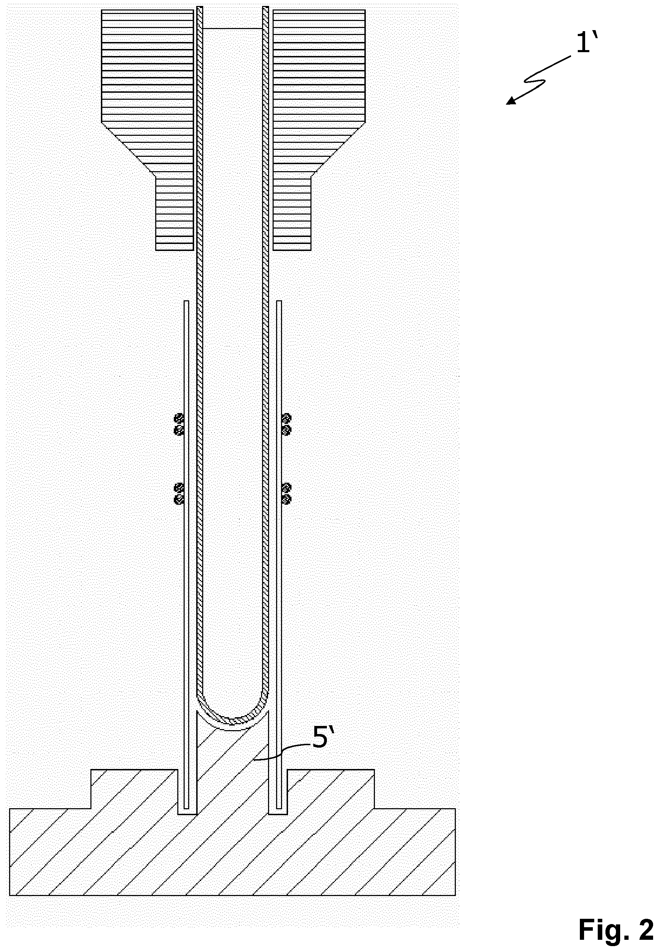

Das Kompensationselement 5 ist in z-Richtung beweglich, insbesondere verschiebbar, auf einer in Richtung der z-Achse wirkenden **Federvorrichtung 8** gelagert. Dabei soll das Kompensationselement entgegen der zeichnerischen Darstellung durch die Federvorrichtung gegen das Probenröhrchen gedrückt werden, um hier einen möglichst geringen Spalt freizulassen. Das Kompensationselement ist dabei mit der Federvorrichtung 8 drehbar gelagert, um eine Rotation des Probenröhrchens während einer NMR-Messung möglichst wenig zu behindern. Außerdem ist es austauschbar gestaltet gegen ein anderes Kompensationselement mit einer unterschiedlichen Suszeptibilität. Eine weitere, besonders einfache Variante, die jedoch nicht unter die vorliegenden Ansprüche fällt, ist schematisch in **Fig. 2** dargestellt. Der dort gezeigte **Probenkopf 1**' ähnelt in den meisten Merkmalen dem in Fig. 1 gezeigten Probenkopfes 1, jedoch unterscheidet er sich davon durch die andere Ausgestaltung seines **Kompensationselements 5':**

Bei dieser Variante ist nämlich das Kompensationselement 5' starr in Teile des Probenkopfes 1' in dem betreffenden unteren axialen Bereich integriert und eben nicht beweglich gelagert. Allerdings kann hier das Probenröhrchen 4 auf einem Luftkissen über dem Kompensationselement 5' gelagert sein, welches vorzugsweise durch einen Temperiergasstrom im Probenkopf 1' gebildet wird.

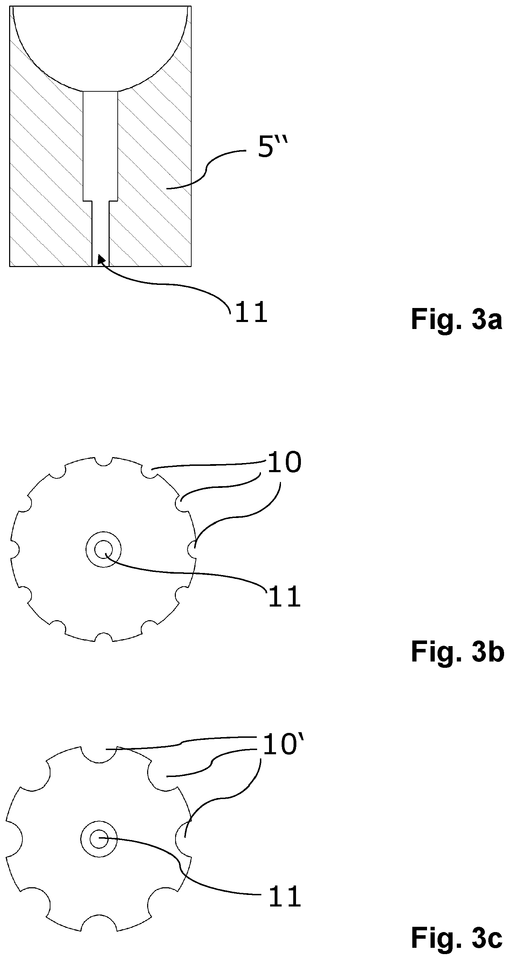

Die **Figuren 3a bis 3c** zeigen Ausführungsbeispiele in größerem Detail, bei denen das **Kompensationselement 5"** Fluiddurchlässe aufweist, nämlich insbesondere an seiner Außenseite in Form von **Längsrillen 10; 10'** parallel zur z-Richtung sowie auf der z-Achse in Form einer axialen **Durchgangsbohrung 11.** Dabei erkennt man in Fig. 3b den zur z-Richtung senkrechten Querschnitt eines Kompensationselements mit feineren, zur z-Richtung parallelen Längsrillen 10 an der Außenseite, während beim Ausführungsbeispiel nach Fig. 3c etwas gröbere Längsrillen 10' vorhanden sind.

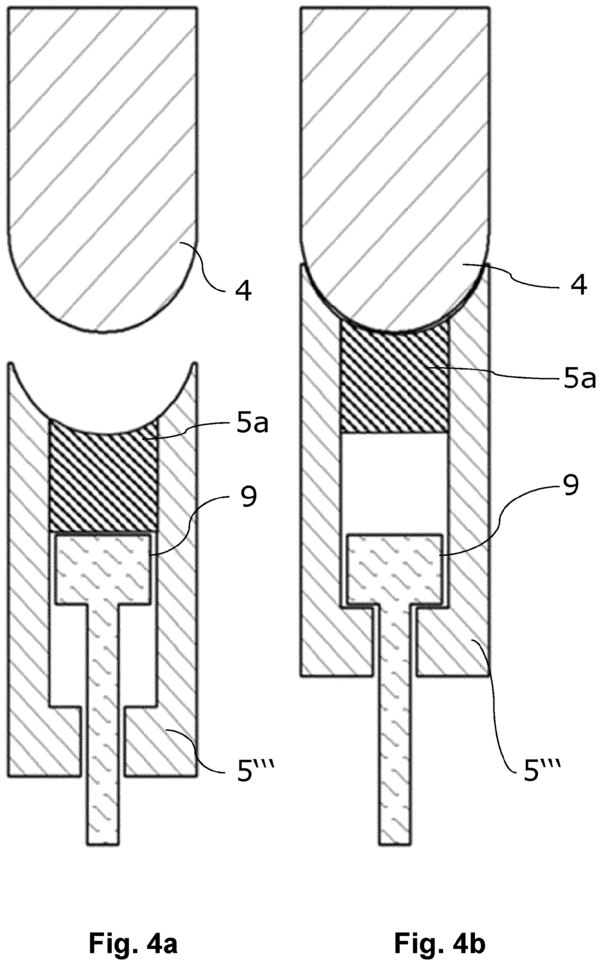

Die **Figuren 4a und 4b** schließlich zeigen eine Ausführungsform eines erfindungsgemäß im NMR-Probenkopf axial unterhalb des Probenröhrchens 4 angeordneten **Kompensationselements 5‴,** welches hohl gestaltet und gegen unkontrolliertes Entfernen aus dem Probenkopf gesichert ist durch ein fest mit dem Probenkopf verbundenes, in das Kompensationselement 5‴ eingreifendes **Halteelement 9.** Dadurch ist auch ein oberer Anschlag in z-Richtung für das Kompensationselement 5‴ vorhanden. Vorteilhaft wird das Kompensationselement durch eine Feder oder den Fluidstrom eines Temperiergases in Richtung des Probenröhrchens gedrückt.

Um die Magnetfeldverzerrung durch den Suszeptibilitätssprung am unteren Endes des Probenröhrchens 4 noch besser zu kompensieren, kann bei einem hohl gestalteten Kompensationselement 5‴ -in der Regel nach erfolgter Montage des Halteelements 9- auch noch ein **Stopfen 5a** aus demselben Material wie das Kompensationselement 5‴ in die dem Probenröhrchen 4 zugewandte Öffnung eingefügt werden.

Während im schematischen Vertikalschnitt nach Fig. 4a das axial in z-Richtung bewegliche Kompensationselement 5‴ in einer mittleren z-Position relativ zu dem fest mit dem Probenkopf verbundenen, in das hohle Kompensationselement 5‴ eingreifenden Halteelement 9 dargestellt ist, zeigt Fig. 4b das Kompensationselement 5‴ relativ zum Halteelement 9 in einer z-Position kurz vor dem axialen Anschlag, um die Reibung mit dem fest mit dem Probenkopf verbundenen Halteelement bei einer Rotation des Probenröhrchens 4 zu minimieren.

Die Merkmale aller oben beschriebenen Ausführungsformen der Erfindung können -jedenfalls größtenteils- auch miteinander kombiniert werden.

### Bezugszeichenliste:

- z: z-Achse der Anordnung
- 1; 1': NMR-Probenkopf
- 2: HF-Sende- und Empfangs-Spulensystem
- 3: in z-Richtung verlaufende Öffnung
- 4: Probenröhrchen
- 5; 5'; 5"; 5‴: Kompensationselement
- 5a: Stopfen
- 6: Ringspalt
- 7: umgebendes Wandelement
- 8: Federvorrichtung
- 9: Halteelement
- 10; 10': Längsrillen
- 11: axiale Durchgangsbohrung

### Referenzliste:

Für die Beurteilung der Patentfähigkeit in Betracht gezogene Druckschriften
[1] US 4,365,199 A
[2] US 9,500,726 B2 ≈ DE 10 2013 204 131 B3
[3] US 6,563,317 B2 ≈ EP 1 239 296 B1 ≈ DE 101 11 672 C2
[4] http://www.wilmad-labglass.com
[5] US 5,545,994 A
[6] US 5,684,401 A
[7] US 7,514,922 B2 ≈ EP 1 909 111 B1 ≈ DE 10 2006 046 888 B4

## Patentansprüche

1. Probenkopf (1) für eine NMR-Apparatur, der ein HF-Sende- und Empfangs-Spulensystem (2) umfasst sowie eine in einer z-Richtung verlaufende Öffnung (3) zur Aufnahme eines Probenröhrchens (4), welches eine mittels NMR-Messung zu untersuchende Probensubstanz enthält, wobei ein Kompensationselement (5; 5'; 5"; 5‴) vorhanden ist, welches Störungen des homogenen Magnetfelds B₀ aufgrund der Probensubstanz und des Materials des Probenröhrchens (4) an dem im Messbetrieb am weitesten in den Probenkopf (1; 1') ragenden Probenende des Probenröhrchens (4) zumindest teilweise kompensiert, wobei das Kompensationselement (5; 5'; 5"; 5‴) außerhalb des im Messbetrieb der NMR-Apparatur in den Probenkopf (1; 1') ragenden Probenröhrchens (4) sowie in z-Richtung unterhalb des Probenendes angeordnet ist, und wobei das Kompensationselement (5; 5"; 5"') in z-Richtung beweglich gelagert ist,
**dadurch gekennzeichnet,**
**dass** das Kompensationselement (5; 5"; 5‴) auf einer in Richtung der z-Achse wirkenden Federvorrichtung (8) gelagert ist,
oder dass das Kompensationselement (5; 5"; 5‴) in z-Richtung beweglich auf einem Luftkissen gelagert ist, und dass das Luftkissen, auf welchem das Kompensationselement (5; 5"; 5‴) gelagert ist, durch einen Temperiergasstrom im Probenkopf (1) gebildet wird.

2. Probenkopf nach Anspruch 1, **dadurch gekennzeichnet, dass** das Kompensationselement (5; 5"; 5‴) frei drehbar um die z-Achse gelagert ist, und insbesondere im Messbetrieb mit dem Probenröhrchen (4) mitrotieren kann.

3. Probenkopf nach einem der vorhergehenden Ansprüche, **dadurch gekennzeichnet, dass** das Kompensationselement (5"; 5‴) hohl gestaltet und vorzugsweise gegen unkontrolliertes Entfernen aus dem Probenkopf (1) gesichert ist, insbesondere durch ein fest mit dem Probenkopf (1) verbundenes, in das Kompensationselement (5"; 5‴) eingreifendes Halteelement (9).

4. Probenkopf nach einem der vorhergehenden Ansprüche, **dadurch gekennzeichnet, dass** in z-Richtung ein oberer Anschlag für das Kompensationselement (5; 5"; 5‴) im Probenkopf (1) vorhanden ist.

5. Probenkopf nach einem der vorhergehenden Ansprüche für eine NMR-Apparatur nach Anspruch 12, **dadurch gekennzeichnet, dass** das Kompensationselement (5"; 5‴) Gasdurchlässe aufweist, insbesondere an seiner Außenseite in Form von Längsrillen (10; 10') parallel zur z-Richtung und/oder auf der z-Achse in Form einer axialen Durchgangsbohrung (11).

6. Probenkopf nach einem der vorhergehenden Ansprüche, **dadurch gekennzeichnet, dass** das Kompensationselement (5; 5'; 5"; 5‴) eine Suszeptibilität χ aufweist, die zwischen der mittleren Suszeptibilität des Probenröhrchens und einer typischen Suszeptibilität der Probensubstanz liegt, vorzugsweise eine Suszeptibilität χ zwischen 0,3cgs und 1cgs, insbesondere eine Suszeptibilität χ zwischen 0,4cgs und 0,8cgs.

7. Probenkopf nach einem der vorhergehenden Ansprüche, **dadurch gekennzeichnet, dass** das Kompensationselement (5; 5"; 5‴) mit Suszeptibilität χ im Probenkopf (1) austauschbar gestaltet ist gegen ein anderes Kompensationselement mit einer unterschiedlichen Suszeptibilität χ'.

8. NMR-Apparatur mit einem Magnetsystem zur Erzeugung eines homogenen statischen Magnetfelds B₀ entlang einer z-Richtung, mit einem Probenkopf (1; 1') nach einem der vorhergehenden Ansprüche.

9. NMR-Apparatur mit einem Probenröhrchen (4) nach Anspruch 8, **dadurch gekennzeichnet, dass** das Kompensationselement (5; 5'; 5"; 5‴) derart ausgebildet ist, dass es die Querschnittsgeometrie des Probenröhrchens (4) in z-Richtung fortsetzt.

10. NMR-Apparatur mit einem Probenröhrchen (4) nach Anspruch 8 oder 9, **dadurch gekennzeichnet, dass** das Kompensationselement (5; 5'; 5"; 5‴) derart ausgebildet ist, dass sich seine Kontur an die Kontur des Probenröhrchens (4) am Probenende anschmiegt, insbesondere, dass das Probenröhrchen (4) am Probenende als Halbkugel und das Kompensationselement (5; 5'; 5"; 5‴) in seinem dem Probenröhrchen (4) gegenüberliegenden Abschnitt als Halbkugelschale ausgebildet sind.

11. NMR-Apparatur nach einem der Ansprüche 8 bis 10, **dadurch gekennzeichnet, dass** das Kompensationselement (5; 5'; 5"; 5‴) aus einem Material gebildet oder mit diesem beschichtet ist, welches den Reibungswiderstand zwischen dem Kompensationselement (5; 5'; 5"; 5‴) und dem im Messbetrieb daran anliegenden Probenröhrchen (4) minimiert, insbesondere Polytetrafluorethylen oder eine Keramiklegierung, wobei das Material vorzugsweise mittlere eine Suszeptibilität χ zwischen 0,4cgs und 0,8cgs aufweist.

12. NMR-Apparatur nach einem der Ansprüche 8 bis 11, **dadurch gekennzeichnet, dass** das Kompensationselement (5; 5'; 5"; 5‴) so ausgestaltet ist, dass ein Fluidfluss, vorzugsweise ein Temperiergasstrom, vom Kompensationselement (5; 5'; 5"; 5‴) in einen Ringspalt (6) zwischen der Außenhülle des im Messbetrieb in den Probenkopf (1; 1') ragenden Probenröhrchens (4) und einem das Probenröhrchen (4) in dieser Position umgebenden Wandelement (7) des Probenkopfes (1; 1'), welches insbesondere das HF-Sende- und Empfangs-Spulensystem (2) trägt, ermöglicht wird.

## Claims

1. A sampling head (1) for an NMR apparatus, which comprises an RF transmission and reception coil system (2) and an opening (3) extending in a z direction for receiving a sample tube (4) containing a sample substance to be analyzed by means of NMR measurement, a compensation element (5; 5'; 5"; 5‴) being present which at least partially compensates for disturbances of the homogeneous magnetic field B₀ due to the sample substance and the material of the sample tube (4) at the end of the sample tube (4) protruding farthest into the sampling head (1; 1') during the measuring operation, the compensation element (5; 5'; 5"; 5‴) being arranged outside the sample tube (4) protruding into the sampling head (1; 1') while the NMR apparatus is in measuring operation and in the z direction below the sampling end,
and wherein the compensation element (5; 5"; 5‴) is movably mounted in the z direction,
**characterized in that**
the compensation element (5; 5"; 5‴) is mounted on a spring device (8) acting in the direction of the z axis,
or that the compensation element (5; 5"; 5‴) is movably mounted in the z direction on an air cushion and that the air cushion on which the compensation element (5; 5"; 5‴) is mounted is formed by a flow of temperature control gas in the sampling head (1).

2. The sampling head according to claim 1, **characterized in that** the compensation element (5; 5"; 5‴) is mounted so as to be freely rotatable about the z axis and, in particular, is able to rotate with the sample tube (4) during measuring operation.

3. The sampling head according to any one of the preceding claims, **characterized in that** the compensation element (5"; 5‴) is designed to be hollow and is preferably protected against uncontrolled removal from the sampling head (1), in particular by a retaining element (9) which is securely connected to the sampling head (1) and engages in the compensation element (5"; 5‴).

4. The sampling head according to any one of the preceding claims, **characterized in that** an upper stop for the compensation element (5; 5"; 5‴) is provided in the sampling head (1) in the z direction.

5. The sampling head according to any one of the preceding claims for an NMR apparatus according to claim 12, **characterized in that** the compensation element (5"; 5‴) has gas passages, in particular on its outside in the form of longitudinal grooves (10; 10') parallel to the z direction and/or on the z axis in the form of an axial through-hole (11).

6. The sampling head according to any one of the preceding claims, **characterized in that** the compensation element (5; 5'; 5"; 5‴) has a susceptibility χ which is between the average susceptibility of the sample tube and a typical susceptibility of the sample substance, preferably a susceptibility χ between 0.3 cgs and 1 cgs, in particular a susceptibility χ between 0.4 cgs and 0.8 cgs.

7. The sampling head according to any one of the preceding claims, **characterized in that** the compensation element (5; 5"; 5‴) with susceptibility χ in the sampling head (1) is designed to be exchangeable for another compensation element with a different susceptibility χ'.

8. An NMR apparatus having a magnet system for generating a homogeneous static magnetic field B₀ along a z direction, with a sampling head (1; 1') according to any one of the preceding claims.

9. The NMR apparatus having a sample tube (4) according to claim 8, **characterized in that** the compensation element (5; 5'; 5"; 5‴) is designed in such a way that it continues the cross-sectional geometry of the sample tube (4) in the z direction.

10. The NMR apparatus having a sample tube (4) according to claim 8 or 9, **characterized in that** the compensation element (5; 5'; 5"; 5‴) is designed in such a way that its contour clings to the contour of the sample tube (4) at the sampling end, in particular that the sample tube (4) at the sampling end is designed as a hemisphere and the compensation element (5; 5'; 5"; 5‴) in its portion opposite the sample tube (4) is designed as a hemispherical shell.

11. The NMR apparatus according to any of the claims 8 to 10, **characterized in that** the compensation element (5; 5'; 5"; 5‴) is formed from or coated with a material which minimizes the frictional resistance between the compensation element (5; 5'; 5"; 5‴) and the sample tube (4) resting against it during measuring operation, in particular polytetrafluoroethylene or a ceramic alloy, the material preferably having an average susceptibility χ between 0.4 cgs and 0.8 cgs.

12. The NMR apparatus according to any of the claims 8 to 11, **characterized in that** the compensation element (5; 5'; 5"; 5‴) is designed so as to allow a fluid flow, preferably a flow of temperature control gas, from the compensation element (5; 5'; 5"; 5‴) into an annular gap (6) between the outer shell of the sample tube (4) protruding into the sampling head (1; 1') during measuring operation and a wall element (7) surrounding the sample tube (4) in this position of the sampling head (1; 1'), which in particular carries the RF transmission and reception coil system (2).

## Revendications

1. Tête d'échantillon (1) destinée à un appareil RMN, laquelle comprend un système de bobines d'émission et de réception HF (2) ainsi qu'une ouverture (3) s'étendant dans une direction z et destinée à recevoir un tube d'échantillon (4) qui contient une substance échantillon à examiner à l'aide d'une mesure RMN, un élément de compensation (5 ; 5' ; 5" ; 5‴) étant prévu qui compense au moins partiellement des perturbations du champ magnétique homogène B₀ dues à la substance échantillon et à la matière du tube d'échantillon (4) à l'extrémité d'échantillon du tube d'échantillon (4) qui fait saillie le plus loin dans la tête d'échantillon (1 ; 1') pendant l'opération de mesure, l'élément de compensation (5 ; 5' ; 5" ; 5‴) étant disposé à l'extérieur du tube d'échantillon (4) qui fait saillie dans la tête d'échantillon (1 ; 1') pendant l'opération de mesure de l'appareil RMN et au-dessous de l'extrémité d'échantillon dans la direction z, et l'élément de compensation (5 ; 5" ; 5‴) étant monté de manière mobile dans la direction z,
**caractérisée en ce que**
l'élément de compensation (5 ; 5" ; 5‴) est monté sur un dispositif à ressort (8) agissant dans la direction de l'axe z,
ou l'élément de compensation (5 ; 5" ; 5‴) est monté sur un coussin d'air de manière mobile dans la direction z, et le coussin d'air, sur lequel l'élément de compensation (5 ; 5" ; 5‴) est monté, est formé dans la tête d'échantillon (1) par un flux de gaz de régulation de température.

2. Tête d'échantillon selon la revendication 1, **caractérisée en ce que** l'élément de compensation (5 ; 5" ; 5‴) est monté de manière à pouvoir tourner librement sur l'axe z et peut notamment tourner conjointement avec le tube d'échantillon (4) pendant l'opération de mesure.

3. Tête d'échantillon selon l'une des revendications précédentes, **caractérisée en ce que** l'élément de compensation (5" ; 5‴) est creux et de préférence protégé contre un démontage inopiné de la tête d'échantillon (1), notamment par un élément de retenue (9) qui est relié solidairement à la tête d'échantillon (1) et qui s'engage dans l'élément de compensation (5" ; 5‴).

4. Tête d'échantillon selon l'une des revendications précédentes, **caractérisée en ce qu'**une butée supérieure destinée à l'élément de compensation (5 ; 5" ; 5‴) est prévue dans la tête d'échantillon (1) dans la direction z.

5. Tête d'échantillon selon l'une des revendications précédentes destinée à un appareil RMN selon la revendication 12, **caractérisée en ce que** l'élément de compensation (5" ; 5‴) comporte des passages de gaz notamment sur son côté extérieur sous la forme de rainures longitudinales (10 ; 10') parallèles à la direction z et/ou sur l'axe z sous la forme d'un trou traversant axial (11).

6. Tête d'échantillon selon l'une des revendications précédentes, **caractérisée en ce que** l'élément de compensation (5 ; 5' ; 5" ; 5‴) a une susceptibilité χ qui est comprise entre la susceptibilité moyenne du tube d'échantillon et une susceptibilité typique de la substance échantillon, de préférence une sensibilité χ comprise entre 0,3 cgs et 1 cgs, en particulier une sensibilité χ comprise entre 0,4 cgs et 0,8 cgs.

7. Tête d'échantillon selon l'une des revendications précédentes, **caractérisée en ce que** l'élément de compensation (5 ; 5" ; 5‴) de susceptibilité χ dans la tête d'échantillon (1) est conçu pour être échangeable contre un autre élément de compensation de susceptibilité différente χ'.

8. Appareil RMN comprenant un système magnétique destiné à générer un champ magnétique statique homogène B₀ suivant une direction z, ledit appareil RMN comprenant une tête d'échantillon (1 ; 1') selon l'une des revendications précédentes.

9. Appareil RMN comprenant un tube d'échantillon (4) selon la revendication 8, **caractérisé en ce que** l'élément de compensation (5 ; 5' ; 5" ; 5‴) est conçu de manière à poursuivre la géométrie en coupe transversale du tube d'échantillon (4) dans la direction z.

10. Appareil RMN comprenant un tube d'échantillon (4) selon la revendication 8 ou 9, **caractérisé en ce que** l'élément de compensation (5 ; 5' ; 5" ; 5‴) est conçu de manière à ce que son contour épouse le contour du tube d'échantillon (4) à l'extrémité d'échantillon, en particulier **en ce que** le tube d'échantillon (4) est conçu comme un hémisphère à l'extrémité d'échantillon et l'élément de compensation (5 ; 5' ; 5" ; 5‴) est conçu sous la forme d'une coque hémisphérique dans sa portion opposée au tube d'échantillon (4).

11. Appareil RMN selon l'une des revendications 8 à 10, **caractérisé en ce que** l'élément de compensation (5 ; 5' ; 5'' ; 5‴) est formé ou revêtu d'une matière qui minimise la résistance au frottement entre l'élément de compensation (5 ; 5' ; 5" ; 5‴) et le tube d'échantillon (4) en appui sur celui-ci pendant l'opération de mesure, notamment en polytétrafluoréthylène ou en alliage céramique, la matière ayant de préférence une susceptibilité moyenne χ comprise entre 0,4 cgs et 0,8 cgs.

12. Appareil RMN selon l'une des revendications 8 à 11, **caractérisé en ce que** l'élément de compensation (5 ; 5' ; 5" ; 5‴) est conçu de manière à permettre un flux de fluide, de préférence un flux de gaz de régulation de température, depuis l'élément de compensation (5 ; 5' ; 5'' ; 5‴) jusque dans un espace annulaire (6), ménagé entre l'enveloppe extérieure du tube d'échantillon (4) qui fait saillie dans la tête d'échantillon (1 ; 1') pendant l'opération de mesure, et un élément de paroi (7) de la tête d'échantillon (1 ; 1') qui entoure le tube d'échantillon (4) dans cette position et qui porte notamment le système de bobines d'émission et de réception HF (2).
